# EUROPEAN PATENT SPECIFICATION

(11) **EP 4 579 252 B1**
(45) Date of publication and mention of the grant of the patent: **11.11.2026**
(21) Application number: 23880065.0
(22) Date of filing: 22.09.2023
(51) Int. Cl.: G01R 31/28, G01R 1/04

(54) **CIRCUIT BOARD TEST TERMINAL**
TESTKLEMME FÜR LEITERPLATTE
BORNE DE TEST DE CARTE DE CIRCUIT IMPRIMÉ

(30) Priority: 17.10.2022 KR 20220133602
(43) Date of publication of application: 02.07.2025
(73) Proprietor: LG Energy Solution, Ltd., Seoul 07335 (KR)
(72) Inventor: PARK, Hye Jin, Daejeon 34122 (KR)
(74) Representative: Goddar, Heinz J.
(86) International application number: PCT/KR2023/014566
(87) International publication number: WO 2024/085486

(56) References cited:
- JP-A- 2009 121 992
- KR-A- 20060 133 242
- KR-A- 20080 092 522
- KR-A- 20170 011 553
- KR-A- 20210 049 257
- KR-B1- 100 991 367
- KR-B1- 101 885 462
- US-A1- 2009 298 023
- "IEC 61010-031 ED3: Safety requirements for electrical equipment for measurement, control and laboratory use ? Part 031: Safety requirements for hand-held and hand-manipulated probe assemblies for electrical test and measurement", 30 September 2022 (2022-09-30), pages 1 - 98, XP082038507, Retrieved from the Internet <URL:https://api.iec.ch/harmonized/documents/download/3084385> [retrieved on 20220930]

## Description

### TECHNICAL FIELD

### TECHNICAL FIELD

The present invention relates to a circuit board test terminal, and more particularly, to a terminal for testing an electronic component assembled with a circuit board.

### BACKGROUND ART

Printed circuit boards (PCB) are necessary parts used for almost every electronic equipment, and are printed circuit boards that are wired and provided on insulation plates so as to circuitally connect electric/electronic components. The PCBs each have a structure in which a conductor and an insulator are stacked in the form of a board, and a plurality of electric/electronic components such as semiconductors, capacitors, or resistors may be mounted thereon. The mounted electric/electronic components may be electrically connected to each other through an electric line circuit printed on the PCB. In the PCB, electric lines may be efficiently designed to reduce a size of an electronic equipment, and improve performance and productivity thereof.

The plurality of electric/electronic components mounted on the PCB may transmit or receive electrical signals. However, when an amount of electrical signals to be transmitted or received increases or high-speed processing of signals is required, a phenomenon in which a signal processing speed is decreased occurs, and this causes performance degradation of the PCB. In order to resolve the decrease in signal processing speed, methods such as a method of increasing the number of layers of the PCB to increase accommodating capacity for the components, are used.

Meanwhile, as it is difficult to check through the naked eyes whether the electronic components such as semiconductors, capacitors, or resistors, which are mounted on the PCB, are properly mounted on the PCB, a separate test device may be used to test whether the electronic components normally operate. When the test device is one, a worker may make a test right away with two hands by gripping a test probe with one hand to bring the test probe into contact with a target point on a circuit board, and gripping a ground probe with the other hand to bring the ground probe into contact with a ground point on the circuit board. However, if there are various types of test devices, testing with the test devices one by one as above causes problems that it takes much time to perform the testing, and results output by the test devices cannot be visually seen at a glance. In addition, when the testing is performed at once by connecting test probes to test points provided on the PCB, respectively, by using a method such as soldering so as to connect the various types of test devices to the target points on the circuit board at once, there are problems that the probes may be in contact with each other to cause an electrical short-circuit, and there is inconvenience to perform a separate process so as to remove the test probes having been connected through soldering or the like after the testing is performed.

Accordingly, there is a need for technical development to solve the problems as above.

KR 101885462 B1 discloses an electronic kit for circuit testing. The kit comprises a breadboard having a plurality of ports into which at least one electrical component can be inserted, and a first printed circuit board arranged below the breadboard and electrically connected to the components inserted into the breadboard. Furthermore, a microcontroller board (Arduino) is provided below the breadboard. A second printed circuit board is arranged on the Arduino and comprises a plurality of pin headers on its lower surface, which are selectively connectable to corresponding pin sockets of the Arduino. A connector is further provided for selectively coupling the first printed circuit board and the second printed circuit board, thereby enabling electrical connections between the breadboard and the Arduino.

US 2009/298023 A1 discloses an electronic circuit study kit comprising a breadboard arrangement with a metallic base, an insulating interconnection sheet carrying power, ground and interconnection pads, and a circuit board with terminal and connection holes aligned with these pads. The structure further includes an insulating plate and a fastening arrangement for combining the components into an integrated assembly.

IEC 61010-031. "Safety requirements for electrical equipment for measurement, control, and laboratory use - Part 031: Safety requirements for hand-held and hand-manipulated probe assemblies for electrical test and measurement (IEC 61010-031:2022)" specifies safety requirements for hand-held and hand-manipulated probe assemblies for electrical test and measurement, and their related accessories.

### SUMMARY

### TECHNICAL PROBLEM

An object of the present invention for solving the above problems is to provide a circuit board test terminal capable of rapidly performing testing at once without an electrical short-circuit occurring between various types of test devices when an electronic component element, an electric circuit, or the like, which is mounted on a circuit board, is tested for whether to properly operate.

### TECHNICAL SOLUTION

As one embodiment of the present invention, the present invention provides a circuit board test terminal including a board part, and an extension part extending from the board part to be connected to a test point of a circuit board, wherein the board part includes: a plate unit that supports a lower portion; a partition unit disposed on the plate unit to divide the plate unit into a plurality of areas, and having a predetermined height; and a terminal unit disposed on each of the divided areas, wherein a test probe that tests the circuit board is in contact with the terminal unit. A holding groove having a predetermine depth is defined in an upper end of the partition unit along an edge of the partition unit.

An inclination guide groove may be defined in a top surface of the terminal unit, wherein the inclination guide groove is a groove having a predetermined inclination to be inclined toward the holding groove defined in the partition unit adjacent thereto.

A vertical guide groove to which an end of the test probe is vertically inserted may be defined in the terminal unit.

The vertical guide groove may be defined in a central portion of the terminal unit.

The partition unit may include an electrical insulation material.

The extension part may include an extension unit having one end that is connected to the terminal unit, and a coupling unit coupled to the other end of the extension unit and coupled to the test point.

The coupling unit may be separated from and coupled to the extension unit.

The coupling unit may have an end having a ring shape.

The extension unit may be provided in plurality, and one end of each of a plurality of extension units may be connected to a different terminal unit. The coupling unit may be coupled to the other end of each of the extension units so as to be coupled to a plurality of test points.

The circuit board test terminal may further include a connecting unit that electrically connects the terminal unit to the extension unit, wherein the connecting unit is coupled to one side of the terminal unit.

As another embodiment of the present invention, the present invention may include a circuit board test terminal according to the invention, and a test device including a test probe having an end, which is in contact with the circuit board test terminal, and a ground probe connected to a circuit board to be grounded, wherein a test probe that tests the circuit board is on contact with the terminal unit.

### ADVANTAGEOUS EFFECTS

According to the present invention, when the electronic components mounted on the circuit board are tested for whether to normally operate, the various types of test devices may be simply connected to perform the testing at once so that the testing is rapidly performed. The testing may be performed at once through the various types of test devices to easily compare the values measured by the test devices. In addition, the test devices necessary for performing the testing may be rapidly separated even after the testing is performed.

### BRIEF DESCRIPTION OF THE DRAWINGS

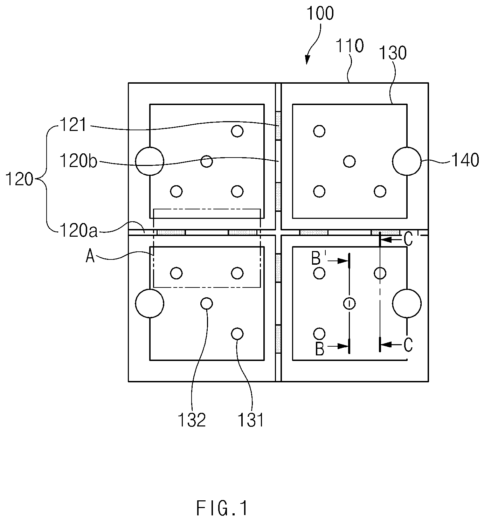

FIG. 1 is a schematic plan view illustrating a board part according to the present invention.
FIG. 2 is a perspective view illustrating a state in which a test probe is held in each of an inclination guide groove and a holding groove in a portion A in FIG. 1.
FIG. 3 illustrates (a) a schematic cross-sectional view taken along line BB' in FIG. 1 and (b) a schematic cross-sectional view taken along line CC' in FIG. 1.
FIG. 4 is a schematic perspective view illustrating a state in which a terminal unit and an extension part are connected to each other through a connecting unit according to the present invention.
(a) to (d) of FIG. 5 are schematic views illustrating a coupling unit according various embodiments of the present invention.
FIG. 6 is a schematic perspective view illustrating a state in which an extension part is connected to an electronic component mounted on a circuit board according to the present invention.
FIG. 7 is a schematic plan view illustrating a circuit board test assembly according to an embodiment of the present invention.

### DETAILED DESCRIPTION

Hereinafter, preferred embodiments of the present invention will be described in detail with reference to the accompanying drawings to enable those skilled in the art to which the present invention pertains to easily carry out the present invention. The present invention may, however, be embodied in different forms and should not be construed as limited by the embodiments set forth herein.

The parts unrelated to the description, or the detailed descriptions of related well-known art that may unnecessarily obscure subject matters of the present invention, will be ruled out in order to clearly describe the present invention. Like reference numerals refer to like elements throughout the whole specification.

Moreover, terms or words used in this specification and claims should not be restrictively interpreted as ordinary meanings or dictionary-based meanings, but should be interpreted as meanings and concepts conforming to the scope of the present invention on the basis of the principle that an inventor can properly define the concept of a term to describe and explain his or her invention in the best ways.

### Circuit board test terminal (10)

As one embodiment of the present invention, the present invention relates to a circuit board test terminal 10 (hereinafter referred to as a "test terminal"), and the test terminal 10 may include a board part 100 and an extension part 150.

The board part 100 is a component to which a test probe 210 is connected, and the board part 100 may include a plate unit 110, a partition unit 120, and a terminal unit 130.

The plate unit 110 may have a flat shape having a predetermined area and thickness, and provide a bottom part of the test terminal 10.

The planar shape of the plate unit 110 may be, for example, a rectangular shape, a circular shape, or the like, but is not limited thereto.

The plate unit 110 may be disposed below the partition unit 120 and the terminal unit 130.

The plate unit 110 may be made of an electrical insulation material to prevent current from flowing between a lower portion of the plate unit 110 and the terminal unit 130. Accordingly, even when the board part 100 is moved to any position, the plate unit 110 may prevent electric noise from being introduced into the terminal unit 130 from a lower portion of the board part 100.

The partition unit 120 may be a wall having a small thickness, which is disposed on a top surface of the plate unit 110 and provided in a direction perpendicular to the top surface so as to divide the plate unit 110 into a plurality of areas.

The partition unit 120 may be made of an electrical insulation material to shield a plurality of terminal units 130 from each other so that a short-circuit is prevented from occurring.

As one embodiment, the partition unit 120 may include a horizontal part 120a and a vertical part 120b.

The horizontal part 120a may be disposed to be parallel to an edge of one surface of the plate unit 110 and the top surface of the plate unit 110, and divide the top surface of the plate unit 110 into a plurality of areas.

The horizontal part 120a may be provided in one or plurality, and a plurality of horizontal parts 120a may be disposed on the top surface of the plate unit 110 according to a predetermined interval or arrangement.

The vertical part 120b may be disposed in a direction perpendicular to the horizontal part 120a, or disposed to cross the horizontal part 120a at a predetermined angle.

A holding groove 121 is defined in an upper end of the partition unit 120.

The holding groove 121 has a predetermined depth, which is disposed along an edge of the upper end of the partition unit 120 in at least a partial region of the edge.

The shape of the holding groove 121 may be, for example, a faceted shape, a curved surface shape, or the like, but is not limited thereto.

The test probe 210 may be held in the holding groove 121. As an end of the test probe 210 is in contact with the terminal unit 130, and also a side surface part of the test probe 210 is in contact with the holding groove 121, the test probe 210 may be held in the holding groove 121 while forming a predetermined angle. A circuit board may be tested through the test probe 210 held in the holding groove 121, and while the test probe 210 is held in the holding groove 121, a worker may perform another work so that work efficiency is improved.

The terminal unit 130 may be disposed in each of the areas divided by the partition unit 120 on the plate unit 130.

The terminal unit 130 may include an electrically conductive metal material so as to be in contact with and electrically connected to the test probe 210. For example, the electrically conductive metal material may be copper, aluminum, gold, silver, or the like.

The terminal unit 130 may have an area and a shape corresponding to the shape of the area divided by the partition unit 120.

The terminal unit 130 may be provided in the form of a plate having a predetermined thickness and width in order to resolve inconvenience caused by testing in which the test probe 210 is in direct contact with a pin or the like of a very small electronic component 320 mounted on a circuit board 300 according to the related art. Thus, the worker may solely bring the test probe 210 into contact with the terminal unit 130 to obtain effects the same as those when the test probe 210 is in direct contact with the pin, a printed electric circuit, or the like of the very small electronic component 320, which is connected to the terminal unit 130 through and the extension part 150. In addition, the testing may be simply performed to remarkably improve the work efficiency.

An inclination guide groove 131 and a vertical guide groove 132 may be defined in the terminal unit 130.

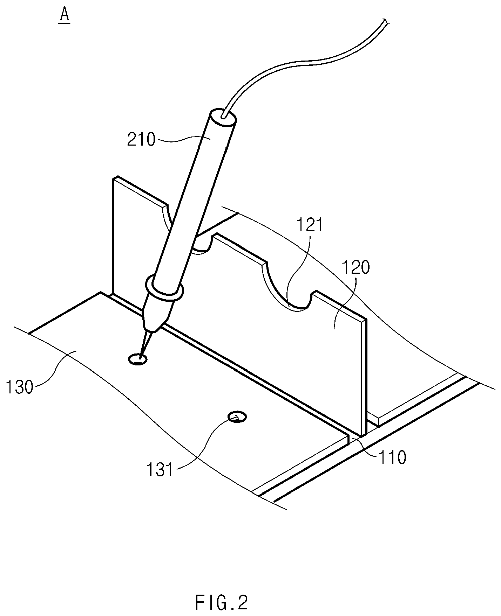

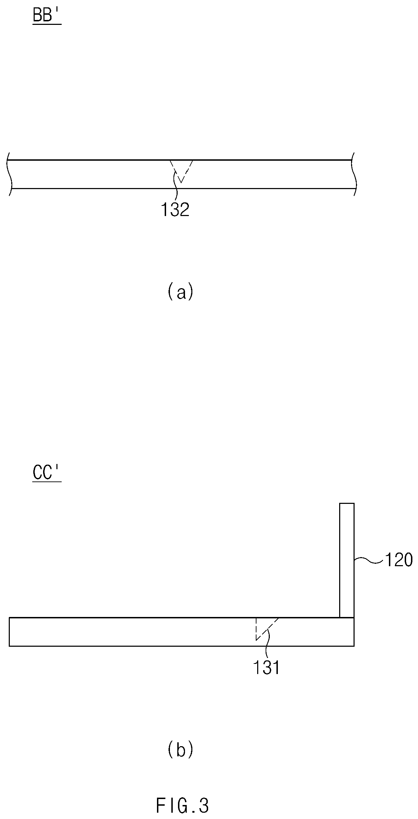

Referring to (b) of FIG. 2 and FIG. 3, the end of the test probe 210 may be inserted into the inclination guide groove 131 to increase a contact area between the test probe 210 and the terminal unit 130, and to provide an inclination in a direction, in which the test probe 210 is disposed, so that the test probe 210 is heled in the holding groove 121.

The inclination guide groove 131 may be defined to be spaced a predetermined distance from the partition unit 120 on a top surface of the terminal unit 130, and may be disposed to be more adjacent to an edge of the terminal unit 130 than the vertical guide groove 132.

Referring to FIG. 2 and FIG. 3(b), the inclination guide groove 131 may have a predetermined inclination inclined so that a virtual central line connecting a center of an opened top surface of the inclination guide groove 131 to a vertex of a lower end thereof faces the holding groove 121. Accordingly, as the end of the test probe 210 is inserted into the inclination guide groove 131, and the side surface part thereof is held in the holding groove 121, the test probe 210 may stand to be inclined at the predetermined angle. That is, the inclination guide groove 131 and the holding groove 210 corresponding to the inclination guide groove 131 may be disposed to be adjacent at a distance close to each other so that easy holding of the test probe 210 is achieved.

The inclination guide groove 131 may be provided in plurality to be disposed along the edge of the terminal unit 130. As a plurality of inclination guide groove 131 are disposed, a plurality of types of test probes 210 that measure different values from each other may be inserted at once into different inclination guide grooves 131, respectively, in one terminal unit 130, and the plurality of types of test probes 210 may measure at once values of the same electronic component 320 electrically connected to the terminal unit 130.

As the end of the test probe 210 is inserted and fixed to the inclination guide groove 131, a position of the test probe 210 held in the holding groove 121 may also be stably fixed.

Referring to (a) of FIG. 3, the vertical guide groove 132 may be defined in a central portion of the top surface of the terminal unit 130. The vertical guide groove 132 may be disposed so that a virtual central line connecting a center of an opened top surface of the vertical guide groove 132 to a vertex of a lower end thereof faces the center of the opened top surface.

Compared to the inclination guide groove 131, the vertical guide groove 132 may have a deeper depth, and the opened top surface thereof may have a smaller area so that when the end of the test probe 210 is inserted into the vertical guide groove 132, the test probe 210 stands in a direction perpendicular to the top surface of the terminal unit 130 even without being held in the holding groove 121.

As the vertical guide groove 132 and the inclination guide groove 131 are defined in one terminal unit 130, a plurality of types of test probes 210 that measure different values from each other may be inserted at once into inclination guide grooves 131 and vertical guide groove 132, respectively, and the plurality of types of test probes 210 may measure at once values of the same electronic component 320 electrically connected to the terminal unit 130.

The vertical guide groove 132 and the inclination guide groove 131 may be spaced a predetermined distance from each other so that the test probes 210 inserted into the vertical guide groove 132 and the inclination guide groove 131, respectively, are not in contact with each other. When contact between the test probes 210 occurs, current may flow even between the test probes 210 to cause an electrical short-circuit problem. As the vertical guide groove 132 and the inclination guide groove 131 are spaced a predetermined distance from each other to space the test probes 210, the problem as above may be prevented.

As the end of the test probe 210 is inserted into the vertical guide groove 132 and a position thereof is fixed, a position of the test probe 210 may also be stably fixed.

A connecting unit 140 may be disposed on one side of the terminal unit 130. and connect the terminal unit 130 to the extension part 150.

The connecting unit 140 may be coupled to the one side of the terminal unit 130. The coupling method may be, for example, a method of welding a lower end of the connecting unit 140 to one side of the top surface of the terminal unit 130, a method of screw-coupling the connecting unit 140 to one side of the terminal unit 130 through a spiral thread provided on a body of the connecting unit 140, or the like. However, the coupling method is not limited thereto.

The connecting unit 140 may electrically connect the terminal unit 130 to the extension part 150. The connecting unit 140 may include an electrically conductive metal material so as to electrically connect the terminal unit 130 to the extension part 150. For example, the connecting unit 140 may include a material such as copper, aluminum, silver, gold, or tungsten, but is not limited thereto.

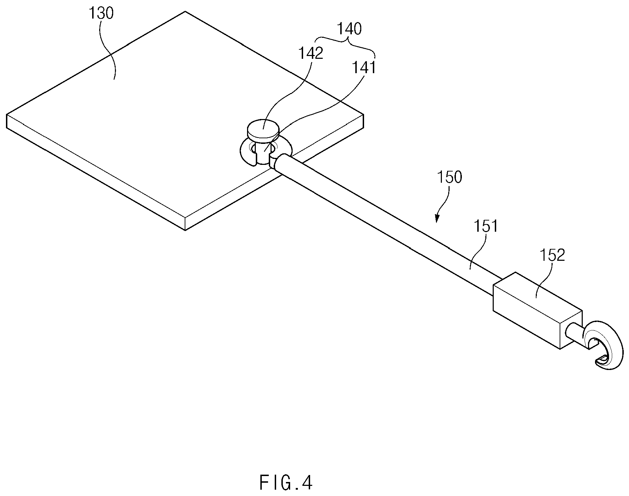

Referring to FIG. 4, the connecting unit 140 may include a body part 141, which is disposed in the direction perpendicular to the top surface of the terminal unit 130, and a head part 142 provided on an upper end of the body part 141. The body part 141 may have a shape such as a cylinder, a rectangular cylinder, or a faceted cylinder, and be coupled to an extension unit 151 of the extension part 150 so that the terminal unit 130 is coupled to the extension part 150.

The extension part 150 may include the extension unit 151 and a coupling unit 152.

The extension part 150 may freely space the board part 100 from the circuit board 300 so that the electronic component 320 or the like mounted on the circuit board 300 is tested using a test device 200 regardless of a position.

The extension unit 151 may have one end connected to the terminal unit 130, and the other end connected to the coupling unit 152. Specifically, the one end of the extension unit 151 may be connected to the body part of the connecting unit 140 coupled to the terminal unit 130.

Referring to FIG. 4, an annular structure made of an electrically conductive metal material may be provided on one end of the extension unit 151. The annular structure may be hooked with the body part 141 of the connecting unit 140 to rapidly connect the extension unit 151 to the connecting unit 140.

The extension unit 151 may include an extension line elongated in a direction from the annular structure provided on the one end to the other end. The extension line may include a metal layer (not shown) made of an electrically conductive material, which is connected to the annular structure provided on the one end of the extension unit 151, and an electrical insulation layer (not shown) which coats an outer surface of the metal layer with an electrical insulation material in a longitudinal direction thereof. A material of each of the metal layer and the electrical insulation layer of the extension line may be a plastically deformable material that is easily bent or has a curved surface provided thereon when force is applied thereto. For examples, the material of the metal layer may be copper, aluminum, or the like, and the material of the electrical insulation layer may be a natural rubber, a synthetic rubber, a synthetic resin, or the like.

The coupling unit 152 may be coupled to the other end of the extension unit 151.

The coupling unit 152 may be coupled to the extension unit 151 through a separable and couplable structure.

The coupling unit 152 may include a coupling part 153, a support 154, and each of ring parts 152a, 152b, 152c and 152d.

The coupling part 153 capable of coupled to the other end of the extension unit 151 may be provided on one end of the coupling unit 152. The coupling part 153 may be, for example, a bolt or the like, and the coupling part 153 may be coupled to the other end of the extension unit 151 through separable and couplable bolt coupling.

The support 154 may have one end provided with the coupling part 153, and the other end provided with each of the ring parts 152a, 152b, 152c and 152d.

The support 154 may be provided in the form of a faceted cylinder, for example, a rectangular cylinder, a pentagonal cylinder, or the like. As the support 154 has a shape of a faceted cylinder, the support 154 may be stably positioned without rolling on the circuit board 300. Thus, a position, at which each of the ring parts 152a, 152b, 152c and 152d is coupled to electronic components 320 on the circuit board 300, and a position adjacent thereto may be stably supported.

As the support 154 includes an electrical insulation material, current may not be allowed to flow to the coupling unit 152 through the support 154 even when the support 154 is in contact with other printed electric circuit or the like on the circuit board 300.

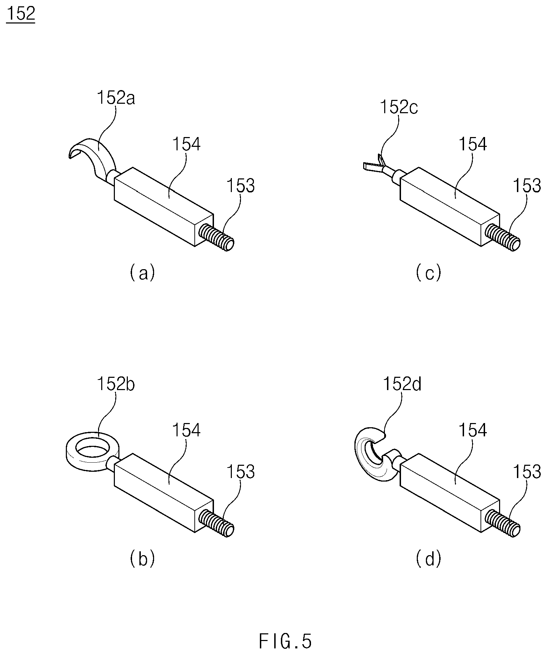

Hereinafter, the ring parts 152a, 152b, 152c and 152d according to various embodiments will be described with reference to FIG. 5.

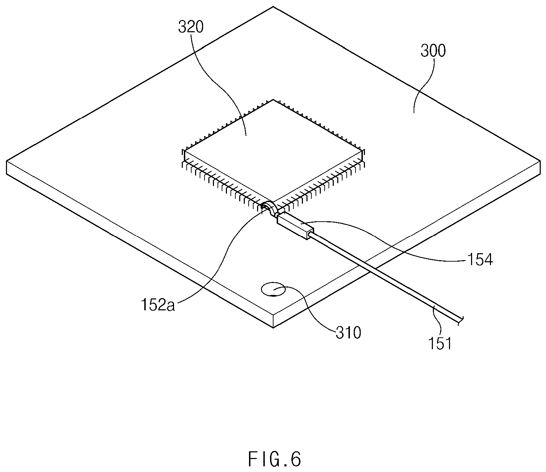

Referring to (a) of FIG. 5 and FIG. 6, as one embodiment of the present invention, a first ring part 152a may be provided on the other end of the coupling unit 152. The first ring part 152a may have a shape having a circumference that is at most half of a circumference of a circular ring. However, the first ring part 152a is not limited to the circular ring, and may have a shape of an oval ring or other closed curve ring. The first ring part 152a may have a structure capable of being easily hooked with a pin or the like of the electronic component 320 of the circuit board 300 so that the first ring part 152a is rapidly coupled. The first ring part 152a may be made of an electrically conductive metal material, and an outer surface thereof except an inner surface of the ring, which is in contact with the pin, may be coated with an electrical insulation material so as to prevent a short-circuit caused by contact with another pin adjacent to the pin.

Referring to (b) of FIG. 5, as another embodiment of the present invention, a second ring part 152b may be provided on the other end of the coupling unit 152. The second ring part 152b may have a shape of a circular ring. The second ring part 152b may be made of an electrically conductive metal material, and an outer surface thereof except an inner surface of the circular ring, which is in contact with a pin of the electronic component 320, may be coated with an electrical insulation material so as to prevent a short-circuit caused by contact with another pin adjacent to the pin.

Referring to (c) of FIG. 5, as still another embodiment of the present invention, a third ring part 152c may be provided on the other end of the coupling unit 152. The third ring part 152c may have a shape of a "V"- or "Y"- shaped ring. The third ring part 152c may be made of an electrically conductive metal material, and an outer surface thereof except an inner surface of the "V"- or "Y"- shaped ring, which is in contact with a pin of the electronic component 320, may be coated with an electrical insulation material so as to prevent a short-circuit caused by contact with another pin adjacent to the pin.

Referring to (d) of FIG. 5, as still another embodiment of the present invention, a fourth ring part 152d may be provided on the other end of the coupling unit 152. The fourth ring part 152d may have a shape having a circumference that is greater than half of a circumference of a circular ring. However, the fourth ring part 152d is not limited to the circular ring, and may have a shape of an oval ring or other closed curve ring. The fourth ring part 152d may be made of an electrically conductive metal material, and an outer surface thereof except an inner surface of the ring, which is in contact with a pin of the electronic component 320, may be coated with an electrical insulation material so as to prevent a short-circuit caused by contact with another pin adjacent to the pin.

### Circuit board test assembly (20)

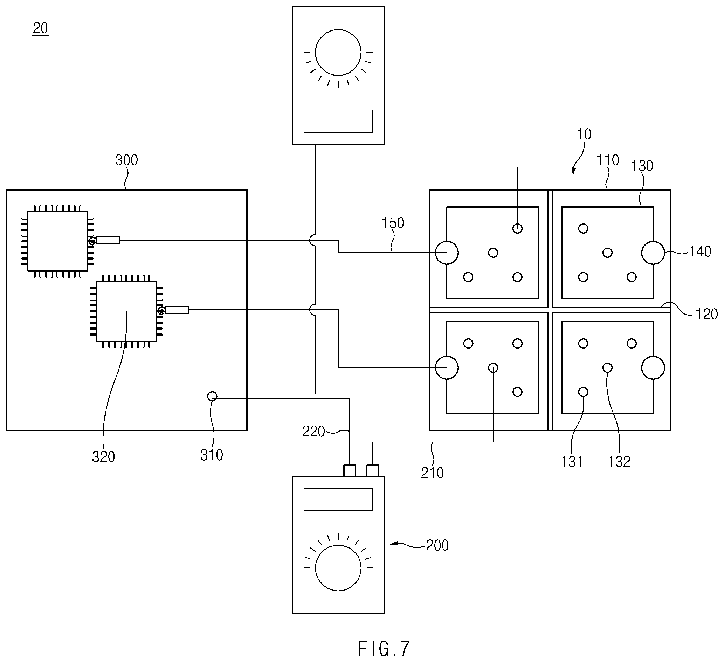

Referring to FIG. 7, a circuit board test assembly 20 may include a circuit board test terminal 10 and a test device 200. The test device 200 may include a test probe 210 having one end, which is in contact with a terminal unit 130 of the circuit board test terminal 10, and a ground probe 220 having one end which is connected to a ground point 310 of a circuit board 300 so as to be grounded.

As the ground probe 220 is grounded, the test device 200 may set a reference value for values measured by the test probe 210, and reduce noise from being introducing into the test probe 210. Accordingly, reliability of the values measured by the test probe 210 may be improved.

The test probe 210 may be in contact with a terminal unit 130 to test whether an electronic component 320, a printed electric circuit, or the like, which is electrically connected to the circuit board test terminal 10, operates normally on the circuit board 300.

The circuit board 300 may include various types of circuit boards, for example, a printed circuit board (PCB), a flexible printed circuit board (FPCB), a rigid-flexible printed circuit board (RF-PCB), and a high density interconnection (HDI) board, and preferably, the circuit board 100 may be a PCB circuit board. However, the circuit board 100 is not limited thereto.

Each of the electronic components 320 in which an electric circuit is printed through printed electronics may be mounted at a predetermined position on the circuit board 300.

The specific description of the circuit board test terminal 10 may be replaced with the content described above.

### [Description of the Symbols]

- 10:: Circuit board test terminal
- 20:: Circuit board test assembly
- 100:: Board part
- 110:: Plate unit
- 120:: Partition unit
- 120:: Horizontal part
- 120:: Vertical part
- 121:: Holding groove
- 130:: Terminal unit
- 131:: Inclination guide groove
- 132:: Vertical guide groove
- 140:: Connecting unit
- 150:: Extension part
- 151:: Extension unit
- 152:: Coupling unit
- 200:: Test device
- 210:: Test probe
- 300:: Circuit board
- 310:: Ground point
- 320:: Electronic component

## Claims

1. A circuit board test terminal (10) comprising:
a board part (100); and
an extension part (150) extending from the board part (100) to be connected to a test point of a circuit board (300),
wherein the board part (100) comprises:
a plate unit (110) configured to support a lower portion;
a partition unit (120) disposed on the plate unit (110) to divide the plate unit (110) into a plurality of areas, and having a predetermined height; and
a terminal unit (130) disposed in each of the divided areas,
wherein a test probe (210) configured to test the circuit board (300) can be brought in contact with the terminal unit (130),
**characterized in that** a holding groove (121) having a predetermine depth is defined in an upper end of the partition unit (120) along an edge of the partition unit (120).

2. The circuit board test terminal (10) of claim 1, wherein an inclination guide groove (131) is defined in a top surface of the terminal unit (130), wherein the inclination guide groove (131) is a groove having a predetermined inclination to be inclined toward the holding groove (121) defined in the partition unit (120) adjacent thereto.

3. The circuit board test terminal (10) of claim 1, wherein a vertical guide groove (132) to which an end of the test probe (210) is vertically inserted is defined in the terminal unit (130).

4. The circuit board test terminal (10) of claim 3, wherein the vertical guide groove (132) is defined in a central portion of the terminal unit (130).

5. The circuit board test terminal (10) of claim 1, wherein the partition unit (120) comprises an electrical insulation material.

6. The circuit board test terminal (10) of claim 1, wherein the extension part (150) comprises:
an extension unit (151) having one end that is connected to the terminal unit (130); and
a coupling unit (152) coupled to the other end of the extension unit (151) and coupled to the test point.

7. The circuit board test terminal (10) of claim 6, wherein the coupling unit (152) is separated from and coupled to the extension unit (151).

8. The circuit board test terminal (10) of claim 6, wherein the coupling unit (152) has an end having a ring shape.

9. The circuit board test terminal (10) of claim 6, wherein the extension unit (151) is provided in plurality, and one end of each of a plurality of extension units (151) is connected to a different terminal unit, and
the coupling unit (152) is coupled to the other end of each of the extension units (151) so as to be coupled to a plurality of test points.

10. The circuit board test terminal (10) of claim 6, further comprising a connecting unit (140) configured to electrically connect the terminal unit (130) to the extension unit (151),
wherein the connecting unit (140) is coupled to one side of the terminal unit (130).

11. A circuit board test assembly (20) comprising:
a circuit board test terminal (10) according to one of claims 1 to 10; and
a test device (200) comprising a test probe (210) having an end, which is in contact with the circuit board test terminal (10), and a ground probe (220) connected to a circuit board (300) to be grounded,
wherein a test probe (210) configured to test the circuit board (300) is in contact with the terminal unit (130).

## Patentansprüche

1. Leiterplatten-Testanschluss (10), umfassend:
einen Leiterplattenabschnitt (100); und
einen Verlängerungsabschnitt (150), der sich von dem Leiterplattenabschnitt (100) erstreckt, um mit einem Testpunkt einer Leiterplatte (300) verbunden zu werden,
wobei der Leiterplattenabschnitt (100) umfasst:
eine Platteneinheit (110), die konfiguriert ist, um einen unteren Abschnitt zu tragen;
eine Trenneinheit (120), die auf der Platteneinheit (110) angeordnet ist, um die Platteneinheit (110) in eine Vielzahl von Bereichen zu unterteilen, und die eine vorbestimmte Höhe aufweist; und
eine Anschlusseinheit (130), die in jedem der unterteilten Bereiche angeordnet ist,
wobei eine Testsonde (210), die konfiguriert ist, um die Leiterplatte (300) zu testen, mit der Anschlusseinheit (130) in Kontakt gebracht werden kann,
**dadurch gekennzeichnet, dass** eine Haltenut (121), die eine vorbestimmte Tiefe aufweist, in einem oberen Ende der Trenneinheit (120) entlang einer Kante der Trenneinheit (120) definiert ist.

2. Leiterplatten-Testanschluss (10) nach Anspruch 1, wobei eine Neigungsführungsnut (131) in einer oberen Oberfläche der Anschlusseinheit (130) definiert ist, wobei die Neigungsführungsnut (131) eine Nut ist, die eine vorbestimmte Neigung aufweist, um in Richtung der Haltenut (121) geneigt zu sein, die in der Trenneinheit (120) benachbart dazu definiert ist.

3. Leiterplatten-Testanschluss (10) nach Anspruch 1, wobei eine vertikale Führungsnut (132), in die ein Ende der Testsonde (210) vertikal eingeführt ist, in der Anschlusseinheit (130) definiert ist.

4. Leiterplatten-Testanschluss (10) nach Anspruch 3, wobei die vertikale Führungsnut (132) in einem mittleren Abschnitt der Anschlusseinheit (130) definiert ist.

5. Leiterplatten-Testanschluss (10) nach Anspruch 1, wobei die Trenneinheit (120) ein elektrisch isolierendes Material umfasst.

6. Leiterplatten-Testanschluss (10) nach Anspruch 1, wobei der Verlängerungsabschnitt (150) umfasst:
eine Verlängerungseinheit (151) mit einem Ende, das mit der Anschlusseinheit (130) verbunden ist; und
eine Kopplungseinheit (152), die mit dem anderen Ende der Verlängerungseinheit (151) gekoppelt ist und mit dem Testpunkt gekoppelt ist.

7. Leiterplatten-Testanschluss (10) nach Anspruch 6, wobei die Kopplungseinheit (152) von der Verlängerungseinheit (151) getrennt und mit dieser gekoppelt ist.

8. Leiterplatten-Testanschluss (10) nach Anspruch 6, wobei die Kopplungseinheit (152) ein ringförmiges Ende aufweist.

9. Leiterplatten-Testanschluss (10) nach Anspruch 6, wobei die Verlängerungseinheit (151) mehrfach vorgesehen ist und ein Ende jeder einer Vielzahl von Verlängerungseinheiten (151) mit einer anderen Anschlusseinheit verbunden ist, und
die Kopplungseinheit (152) mit dem anderen Ende jeder der Verlängerungseinheiten (151) gekoppelt ist, um mit einer Vielzahl von Testpunkten gekoppelt zu werden.

10. Leiterplatten-Testanschluss (10) nach Anspruch 6, ferner umfassend eine Verbindungseinheit (140), die konfiguriert ist, um die Anschlusseinheit (130) elektrisch mit der Verlängerungseinheit (151) zu verbinden,
wobei die Verbindungseinheit (140) mit einer Seite der Anschlusseinheit (130) gekoppelt ist.

11. Leiterplatten-Testanordnung (20), umfassend:
einen Leiterplatten-Testanschluss (10) nach einem der Ansprüche 1 bis 10; und
eine Testvorrichtung (200), umfassend eine Testsonde (210) mit einem Ende, das mit dem Leiterplatten-Testanschluss (10) in Kontakt steht, und eine Erdungssonde (220), die mit einer zu erdenden Leiterplatte (300) verbunden ist,
wobei eine Testsonde (210), die konfiguriert ist, um die Leiterplatte (300) zu testen, mit der Anschlusseinheit (130) in Kontakt steht.

## Revendications

1. Borne de test de carte de circuit imprimé (10) comprenant :
une partie carte (100) ; et
une partie d'extension (150) s'étendant depuis la partie carte (100) devant être connectée jusqu'à un point de test d'une carte de circuit imprimé (300),
où la partie carte (100) comprend :
une unité plaque (110) configurée pour soutenir une portion inférieure ;
une unité de séparation (120) disposée sur l'unité plaque (110) pour diviser l'unité plaque (110) en une pluralité de zones, et ayant une hauteur prédéterminée ; et
une unité borne (130) disposée dans chacune des zones divisées,
où une sonde de test (210) configurée pour tester la carte de circuit imprimé (300) peut être amenée en contact avec l'unité borne (130),
**caractérisée en ce qu'**une rainure de maintien (121) ayant une profondeur prédéterminée est définie dans une extrémité supérieure de l'unité de séparation (120) le long d'un bord de l'unité de séparation (120).

2. Borne de test de carte de circuit imprimé (10) de la revendication 1, où une rainure de guidage d'inclinaison (131) est définie dans une surface supérieure de l'unité borne (130), la rainure de guidage d'inclinaison (131) étant une rainure ayant une inclinaison prédéterminée devant être inclinée vers la rainure de maintien (121) définie dans l'unité de séparation (120) adjacente à celle-ci.

3. Borne de test de carte de circuit imprimé (10) de la revendication 1, où une rainure de guidage verticale (132), au niveau de laquelle une extrémité de la sonde de test (210) est insérée verticalement, est définie dans l'unité borne (130).

4. Borne de test de carte de circuit imprimé (10) de la revendication 3, où la rainure de guidage verticale (132) est définie dans une portion centrale de l'unité borne (130).

5. Borne de test de carte de circuit imprimé (10) de la revendication 1, où l'unité de séparation (120) comprend un matériau d'isolation électrique.

6. Borne de test de carte de circuit imprimé (10) de la revendication 1, où la partie d'extension (150) comprend :
une unité d'extension (151) ayant une extrémité qui est connectée à l'unité borne (130) ; et
une unité de couplage (152) couplée à l'autre extrémité de l'unité d'extension (151) et couplée au point de test.

7. Borne de test de carte de circuit imprimé (10) de la revendication 6, où l'unité de couplage (152) est séparée de et couplée à l'unité d'extension (151).

8. Borne de test de carte de circuit imprimé (10) de la revendication 6, où l'unité de couplage (152) a une extrémité ayant une forme annulaire.

9. Borne de test de carte de circuit imprimé (10) de la revendication 6, où l'unité d'extension (151) est prévue en pluralité, et une extrémité de chacune d'une pluralité d'unités d'extension (151) est connectée à une unité borne différente, et
l'unité de couplage (152) est couplée à l'autre extrémité de chacune des unités d'extension (151) de sorte à être couplée à une pluralité de points de test.

10. Borne de test de carte de circuit imprimé (10) de la revendication 6, comprenant en outre une unité de connexion (140) configurée pour connecter électriquement l'unité borne (130) à l'unité d'extension (151),
où l'unité de connexion (140) est couplée à un côté de l'unité borne (130).

11. Ensemble test de carte de circuit imprimé (20) comprenant :
une borne de test de carte de circuit imprimé (10) selon l'une des revendications 1 à 10 ; et
un dispositif de test (200) comprenant une sonde de test (210) ayant une extrémité, qui est en contact avec la borne de test de carte de circuit imprimé (10), et une sonde de masse (220) connectée à une carte de circuit imprimé (300) devant être mise à la masse,
où une sonde de test (210), configurée pour tester la carte de circuit imprimé (300), est en contact avec l'unité borne (130).
